# EUROPÄISCHE PATENTSCHRIFT

(11) **EP 0 674 319 B1**
(45) Veröffentlichungstag und Bekanntmachung des Hinweises auf die Patenterteilung: **22.08.2001**
(21) Anmeldenummer: 95103383.6
(22) Anmeldetag: 09.03.1995
(51) Int. Cl.: G11C 7/00, G11C 8/00

(54) **Mehrtorige Datenspeicheranordnung und Verfahren zum Betrieb derselben**
Multi-port memory system and its operation method
Système de mémoire à plusieurs portes et méthode d'opération d'un tel système

(30) Priorität: 15.03.1994 DE 4408695
(43) Veröffentlichungstag der Anmeldung: 27.09.1995
(73) Patentinhaber: Marks, Karl Michael, Medford, MA 02155 (US)
(72) Erfinder: Marks, Karl Michael, Medford, MA 02155 (US)
(74) Vertreter: Schmidt, Karl Michael

(56) Entgegenhaltungen:
- EP-A- 0 473 819
- WO-A-92/09025

## Beschreibung

Die Erfindung betrifft eine mehrtorige Datenspeichenanordnung mit mindestens einem Schreib-Lese-Speicherelement nach Art sogenannter Multiport-RAMs, mit zwischen den Toren und dem Speicherelement angeordneten Datenregistern und Zeitmultiplexelementen zum koordinierten Datentransfer zwischen den Toren und dem Speicherelement gemäß Oberbegriff des Patentanspruches 1 sowie ein Verfahren zum Betrieb einer solchen Datenspeicheranordnung gemäß Oberbegriff des Patentanspruches 11

Mehrtorige Datenspeicheranordnungen sind im Stand der Technik oftmals als sogenannte Multi-Port-RAMs oder Multi-Port-SRAMs bekannt. Somit verfügen solche Speicherbausteine über 2, 3, 4 oder in seltenen Fällen mehr als 4 Tore d.h. Ports, über welche Daten in den eigentlichen Speicherbaustein (RAM) einlesbar, bzw. aus demselben herauslesbar sind. Solche Anordnungen sind z.B. von den Motorola Bausteinen Mc 62110 oder Mc 67D709 (jeweilige Handbücher) bekannt. Jeder Port besteht in der Regel aus 9 Ein-/Ausgängen; (1 Byte + 1 Redundanz Bit). Bei Anordnungen dieser genannten Art erfolgt das Ein-/ bzw. Auslesen in, bzw. aus dem Speicherbaustein über Zeitmultiplexelemente koordiniert, weil bei Anordnungen der bekannten Art die Ports nicht gleichzeitig Zugriff auf den Speicherbaustein haben können. Das heißt die einzelnen Ports stehen über Zeit-Multiplexer mit dem Speicherbaustein in Verbindung. Bei bekannten Anordnungen ist es üblich, daß die Kommunikation des Zeitmultiplexers mit dem Speicherbaustein nur über einen Datenpfad erfolgt. Desweiteren sind solche Anordnungen bestehend aus Speicherelement (RAM), Zeit-Multiplexer, und einer Mehrzahl von Ports mit der entsprechend internen Anlegung von Datenleitungen auf einem Chipelement implementiert. Dies kann dann dazu führen, daß durch die Ausbildung des Zugriffes zwischen einem oder mehreren Ports und dem Speicherbaustein sowie durch die übliche On-Chip-Implementierung bei einer Transaktion (Datentransfer), der Zugriff auf das Speicherelement für alle übrigen Ports grundsätzlich blockiert ist.
Durch die zunehmende Erhöhung der Prozessorgeschwindigkeit wird eine Verkürzung der Zugriffszeiten zu den Speicherelementen notwendig. Diese lassen sich nicht mehr durch Optimierung herkömmlicher Zeitmultiplex-Verfahren für den Zugriff auf Datenspeicher erhöhen bzw. verbessern. Von extremer Bedeutung wird eine Optimierung von Zugriffszeiten bei Cachespeichern, da diese in direkter Korrespondenz mit den Mikroprozessoren stehen. Vielfach sind solche Cachespeicher, auf den Mikroprozessorchip mitimplementiert. Häufig sieht man jedoch eine Implementierung von externen Cachespeichern vor, wobei dann zunehmend schnelle Pipeline-SRAMs benötigt werden. Bei diesen RAMs handelt es sich um sogenannte Statik RAMs, abgekürzt SRAMs. Diese stehen entweder eintorig, als sogenannte Single-Port-SRAMs oder als zweitorige sogenannte Dual-Port-SRAMs zu Verfügung. Einige spezielle Dual-Port-SRAMs, wie der oben genannte MC 62110, haben zusätzlich die Möglichkeit, unabhängig von der Beteiligung des internen SRAMs an der aktuellen Transaktion, die Daten von einem zum anderen Port direkt durchzuschleusen. Das heißt die Daten fließen dabei zwischen den einzelnen Toren, direkt; d.h. nicht über das Speicherbauelement. Eine solche Vorgehensweise nennt man Bypassing. Wie oben bereits gesagt, tritt die Notwendigkeit eines schnellen Zugriffes des Mikroprozessors auf das Speicherelement insbesondere bei Cachespeichern zutage. Die bekannten Implementierungen koppeln im Betrieb jeweils einen Port mit dem Speicherelement. Die anderen Ports sind während der Transaktion zwischen dem Speicherelement und dem verbundenen Port vom Zugriff ausgeklammert.

Nachteilig ist es daher, daß zu einem Zeitpunkt immer nur eine Transaktion abgewickelt werden kann, da für jeden Datenzyklus entweder direkt auf das SRAM zugegriffen wird, oder durch das Bypassing die Ports belegt sind. So werden z.B. für einen Burst mit 4 Datentransfers 4 interne SRAM-Zugriffe durchgeführt. Bei den Single Port SRAMs, welche bei sogenannten Lookaside-Cache-Konfigurationen realisiert sind bei denen nur ein Port zum Cache vorgesehen ist, ist dies natürlich nicht störend.
Störend wird dieser Effekt jedoch bei hierarchischen Cache-Konfigurationen, bei denen eine Transaktion auf einem Port eine unabhängige Transaktion (nicht durch Bypassing gekoppelt ) auf dem anderen Port ausschließt.

Wie oben bereits dargestellt, wird somit die Zugriffszeit auf den Speicher immer mehr zum limitierenden Faktor für die Taktfrequenz bei der Versorgung von Bursts.

Aus der EP 0 136 218 ist eine Anordnung bekannt, mit einem parallelen Input, den man hier als Tor bzw. als Port bezeichnen kann. Diese einzelnen parallelen Inputs sind dabei jeweils mit seriellen Pufferspeichern oder Registern versehen, um eine limitierte Anzahl von Datenbits zwischenspeichern zu können, bevor diese über einen Multiplexer geführt werden.
Der Multiplexer nimmt dabei den zeitkoordinierten Direktzugriff auf das Speicherbauelement ( RAM) vor. Hierbei ist es zwar möglich, daß am Input-Port die Daten bzw. die Bursts zunächst zwischengespeichert oder abgelegt werden können, und der Multiplexer in zeitoptimierter Weise den Direktzugriff auf das Speicherbauelement vornimmt. Das Anlegen von Zwischenspeichern erhöht dabei zwar die Verfügbarkeit und die Auslastung hinsichtlich des Zugriffes auf den Speicher, jedoch ist der Zugriff zwischen Multiplexer und Speicherbauelement nur über eine einfache Datenleitung bewerkstelligt. Eine Anordnung dieser Art genügt den Anforderungen hinsichtlich der Zugriffszeitoptimierung moderner Prozessoren nicht mehr. Außerdem fehlt der direkte Pfad zwischen den Ports.

Ausgehend von diesem Stand der Technik liegt der Erfindung daher die Aufgabe zugrunde, eine schaltungsmäßige Auslegung sowie ein Betriebsverfahren einer Datenspeicheranordnung gemäß Oberbegriff der Patentansprüche 1 und 11 dahingehend auszubilden, daß es möglich ist, einen Speicherbaustein in verschiedenen Anwendungen/Konfigurationen universell einsetzen zu können, und außerdem eine Erhöhung der Datentransferbandbreite zu erreichen.

Die gestellte Aufgabe ist bei einer mehrtorigen Datenspeicheranordnung gemäß Oberbegriff des Patentanspruches 1 erfindungsgemäß durch die kennzeichnenden Merkmale des Patentanspruches 1 gelöst. Hinsichtlich eines Verfahrens zur Steuerung einer solchen Speicheranordnung gemäß Oberbegriff des Patentanspruches 11 sind erfindungsgemäß die kennzeichenenden Merkmale des Patentanspruches 11 angegeben.

Weitere Ausgestaltungen hinsichtlich der Datenspeicheranordnung, sowie des Verfahrens zum Betrieb derselben sind in den abhängigen Ansprüchen angegeben.

Der Kern der Erfindung besteht darin, daß die Tore jeweils eine Wortbreite von n Bit aufweisen, daß das Speicherelement (RAM) n Ebenen aufweist, und jede Ebene einem der n Bits zugeordnet ist, daß auf jeder Ebene das Speicherelement m Bits breit ist, wobei m größer oder gleich 2 ist, und eine Datentransfer-Anschlußebene (DAE) mit einem Dateneingang und einem Datenausgang für jedes der m Bits aufweist, und daß auf jeder Ebene die genannten Datenregister und Zeitmultiplexmittel vorgesehen sind um einerseits die genannten Tore untereinander und andererseits die genannten Tore mit den genannten Datenein- und -ausgängen zu verbinden.
Das heißt also mit anderen Worten , daß das Speicherelement Raum-Vielfach (Raummultiplex) angelegt ist und in der Datentransfer-Anschlußebene mit m*n Bit Daten-Ein/-Ausgängen versehen ist, und die Tore jeweils n Bit breit sind und mit den Datenregistern und dem Speicherelement derart verschaltet sind, daß die jeweils n-te Ebene der Tore über Zeitmultiplexelemente untereinander und mit der jeweiligen n-ten Ebene des Speicherelementes auf einer Breite von m Worten verbunden ist.
Die Kombination von schlechthin Raummuliplex mit Zeitmultiplex ist zwar aus der Telekommunikationstechnik bekannt, jedoch für den Einsatz von Datenspeicheranordnungen innerhalb der Rechnerarchitektur bisher nicht für realisierbar gehalten worden. Bei der vorliegenden Erfindung ist die Kombination Raumvielfach mit Zeitvielfach (Raummuliplex mit Zeitmultiplex) mit einer entsprechenden hardwaremäßigen Auslegung der Tore und des Speicherelementes kombiniert. Auf diese Weise ist es dann möglich eine solche Raummultiplex/Zeitmultiplex- Kombination auch für Speicherbauelemente zu realisieren. In Ausgestaltung der einrichtungsmäßigen Erfindung ist dieselbe bei Cachespeichern angewendet. In weiterer Ausgestaltung der Erfindung verfügt jedes Tor, d.h. jeder Port über eigene Registerelemente getrennt nach Ein- und Ausgabe, im Gegensatz zur EP 0 136 218.
Die jedem Tor zugeordneten eigenen Registerelemente sind dabei nach einer jeweils eigenen Struktur derart verschaltet, daß hier eine komplette, maximale Transaktion (Bursts) der Länge BS sowohl in empfangender als auch in sendender Richtung zwischengespeichert werden kann. In weiterer Ausgestaltung ist vorgesehen, daß die einzelnen Register über Zeitmultiplexelemente mit der Datentransfer-Anschlußebene des Speicherelementes verbunden und darüber hinaus über die den jeweiligen Toren bzw. Ports zugeordneten Registern und Zeitmultiplexelementen auch untereinander zwecks direkter Übertragung von Daten zwischen den Ports verbunden sind. Dadurch wird ein Bypassing ermöglicht, bei dem im Gegensatz zum oben zitierten Stand der Technik, während des Bypassings der direkte Zugriff im Hinblick auf eine weitere unabhängige Transaktion auf das Speicherbauelement RAM nicht blockiert ist. Weiterhin enthält jedes Tor in jeder n-ten Ebene eine Anzahl von m parallelen Registern, die mit der jeweiligen n-ten Ebene bzw. mit dem jeweilig entsprechenden Anschluß des Tores über ein Eingangszeitmultiplexelement verbunden sind. Weiter ist das jeweilige Ausgangszeitmultiplexelement schaltungsmäßig zwischen dem jeweiligen n-ten Pin des jeweiligen Tores und den jeweiligen m Registern der entsprechenden n-ten-Ebene angeordnet. Weitere Elemente für die Durchführung des direkten Bypassing, sowie die Ablegung von Daten zwischen den Ports und den einzelnen Zeitmultiplexelementen räumlich vor dem Speicherelement sind in den weiteren Ausgestaltungen der übrigen Unteransprüche angegeben.

Daraus ergibt sich, daß das RAM intern so breit organisiert ist, daß mit einem RAM-Zugriff die gesamte, maximale Datenmenge für ein Transaktion (Burst) zur Verfügung gestellt wird. Das RAM wird in besonderer Ausgestaltung mit einer beliebigen Anzahl 9-Bit breiter Ports ausgestattet. Jedes einzelne dieser 9 Bit ist über entsprechende Register 8 Worte breit angelegt. Jedes Port enthält, wie oben dargestellt, eine eigene Registerstruktur, die somit in der Lage ist, je eine komplette maximale Transaktion (Burst der Länge BS) im empfangender und sendender Richtung zwischenspeichern zu können.

Neben den Datenverbindungen zum internen RAM erhalten die Registerstrukturen gemäß der oben dargestellten Ausgestaltung, spezielle Verbindungen untereinander, welche die direkte Übertragung von Daten zwischen den Ports sogenanntes Bypassing erlauben. Entsprechend der aufgabengemäßen Forderung erlaubt die erfindungsgemäße Einrichtung nunmehr die Entkopplung der Datentransfers an den Ports von den eigentlichen Speicherzugriffen. Dadurch wird es möglich, auch bei langsameren Speicherimplementierungen, die Burst aus dem Registerstrukturen mit voller Geschwindigkeit zu bedienen. Darüber hinaus kann, während eine Transaktion auf einem oder mehreren Ports abgewickelt wird, bereits wieder auf den Speicher zugegriffen werden, um Transaktionen auf anderen Ports zu ermöglichen. Dadurch wird die gesamt Bandbreite erhöht und die verschiedenen Busse werden weitgehend voneinander entkoppelt. In der verfahrensmäßigen Auslegung der Erfindung, können gezielt Teilmengen der vom Speicher übernommenen Daten ausgegeben werden bzw. es können ankommende Daten gezielt nur in einen Teil der Registerstrukturen gespeichert werden. Dadurch ist es ermöglicht, mehrere Ports zu einem, logisch breiteren Port zusammen zu legen, gemäß dem angegebenen Betriebsverfahrens. Dies hat den außerordentlichen Vorteil, daß die resultierende größere Gesamtbreite dazu dient, daß ein Cachespeicher bei vorgegebener Busbreite mit weniger Cache SRAMs aufgebaut werden kann. Insgesamt lassen sich durch die Tatsache, daß nunmehr die Bypass-Transaktionen von den direkten Zugriffen zum RAM entkoppelt sind, mit dieser erfindungsgemäßen Ausgestaltung durch Zuhilfenahme eines immer wieder gleich ausgebildeten SRAM Bausteines verschiedene Anwendungen/Konfigurationen zusammenstellen.

Ferner wird auch eine erhebliche Erhöhung der Datentransferbandbreite erreicht, indem nunmehr die Möglichkeit besteht, mehrere Ports in eine gemeinsame Datentransaktion einzubeziehen und somit eine entsprechend hohe Bandbreite zu ermöglichen.

Die Erfindung ist in der Zeichnung dargestellt und im nachfolgenden näher beschrieben.

Es zeigt:
- Fig.1:: Darstellung einer n-ten Ebene der Speicheranordnung
- Fig.2:: Einbindung der Erfindung, bei der vier Ports logisch zu einem Port zusammengefasst sind.
- Eig.3:: logische Zusammenfassung zweier Ports zu einem Port
- Fig.4:: logische Zusammenfassung von jeweils zwei Ports zu jeweils einem Port
- Fig.5:: spezifische Ausnutzung nur eines Ports
- Fig.6:: spezifische Ausnutzung zweier logisch zusammengefasster Ports
- Fig.7:: spezifische Ausnutzung dreier Ports
- Fig.8, Fig.9:: Verdopplung der Cachegröße durch zwei parallele Cache-RAMs, ansonsten wie Fig.6 und Fig.7.

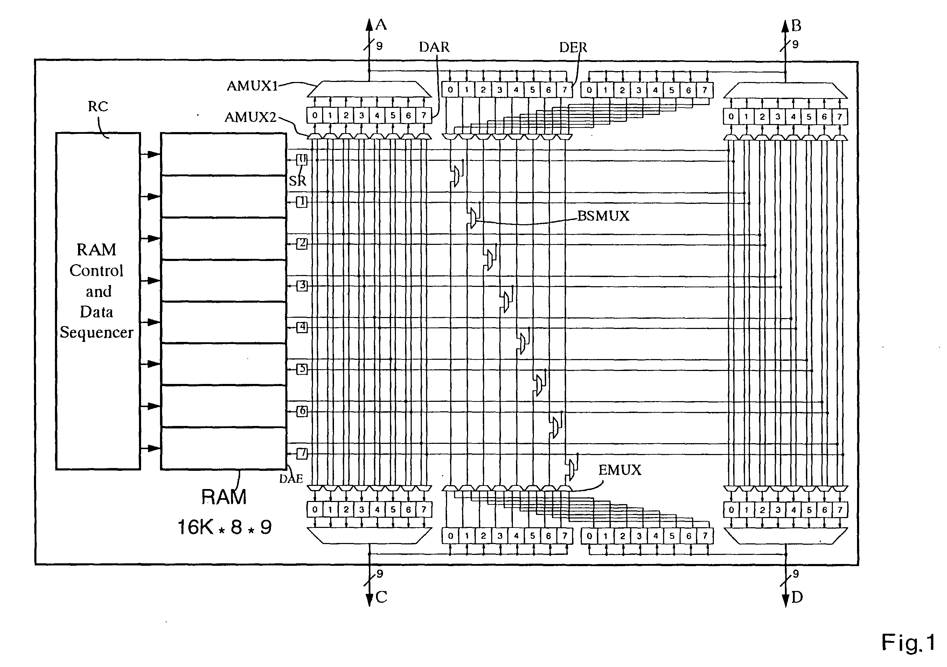

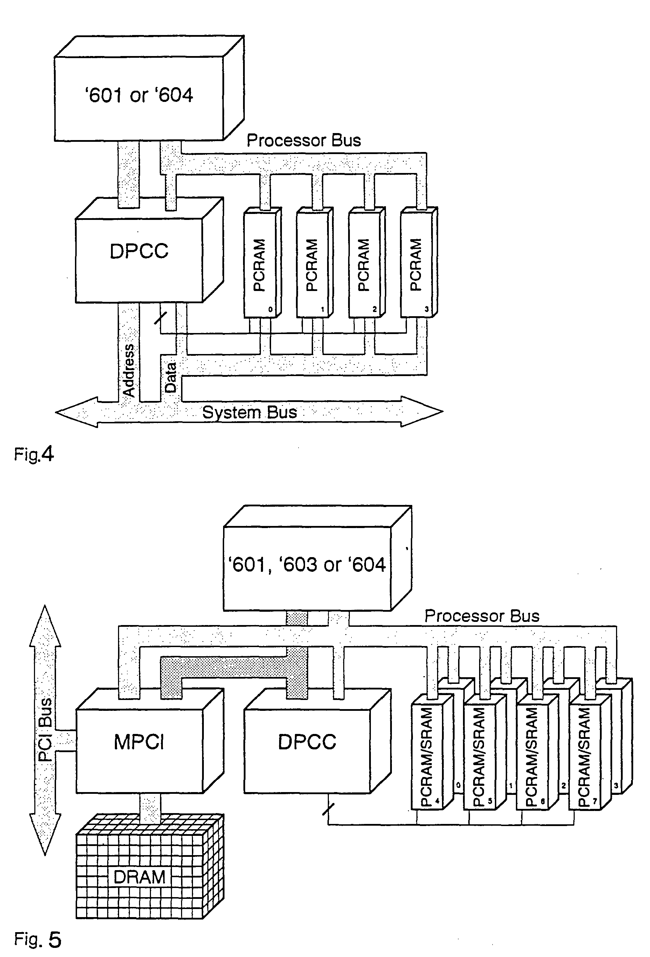

Fig. 1 zeigt die Erfindung bzw. die erfindungsgemäße Speicheranordnung in einer beliebigen n-ten Ebene. Diese Speicheranordnung setzt einen Speicherbaustein RAM ein, welcher m * n Bit Daten-Ein-/-Ausgänge, und eine entsprechende Speichertiefe aufweist.

Ferner weist die Speicheranordnung in dieser Darstellung 4 Ports auf. In diesem Ausführungsbeispiel sind die Ports PORT 9 Bit hoch angelegt, wobei 8 Bit für die Datenworte vorgesehen sind und das verbleibende eine Bit als Redundanz Bit (Prüf Bit) vorgesehen ist. In der Papierebene zu Fig. ist somit eine von 9 Ebenen der Speicheranordnung dargestellt. Das heißt jede der hier 9 Ebenen der Speicheranordnung ist gleich ausgebildet, nämlich gemäß der Darstellung nach Fig.1. Bezieht man sich in dieser Darstellung zu Fig.1 nun auf die nullte Ebene, so setzen sich alle übrigen Ebenen senkrecht zur Papierebene fort. Das Speicherelement RAM ist dieser Darstellung und in diesem Ausführungsbeispiel also 8 Datenworte breit und 9 Bit hoch, d.h. m=8 (Anzahl der Datenworte) und n=9. Das Speicherelement besteht also aus einer Anzahl m Speichersegmenten. Zur Speicheranordnung gehört hierbei auch noch ein RAM-Controler RC welcher den Speicherbaustein RAM und die Multiplexer und Register steuert und außerdem die Adressierung desselben vornimmt.

Die 4 Ports PORT A,B,C,D sind bidirektioal angelegt. Jedes Port, daß heißt jede n-te Ebene der hier 9 vorhandenen Ebenen weist jeweils 8 Dateneingangsregister DER und 8 weitere Datenausgangsregister DAR auf. Diese jeweiligen 8 einzelnen Register sind mit Zeitmultiplexern versehen. Diese Register werden durch entsprechende koordinierte Befüllung und Entleerung quasi seriell, d. h. nacheinander betrieben. Die koordinierte Befüllung bzw. Entleerung erfolgt dabei über die Zeitmultiplexer. Bei den Dateneingangsregistern DER sind Eingangszeitmultiplexelemente EMUX vorgesehen. Dabei sind die Dateneingangsregister DER hier bezüglich der jeweiligen n-ten Ebene miteinander über jeweils ein Eingangszeitmultiplexelement 0-7 des Eingangszeitmultiplexers EMUX verknüpft. Auf der gegenüberliegenden Seite, daß heißt der Seite der anderen beiden Ports, ist der gesamte Eingangsbereich sowie die Anlegung der Register und der Multiplexerelemente spiegelsymmetrisch wiederholt.

Somit sind jeweils die 8 Registerelemente der Dateneingangsregister DER der 4 Ports PORT A, B, C, D zunächst paarweise über jeweils 1 Element des jeweiligen Eingangszeitmultiplexers EMUX verbunden.
Die dabei auf jeder Seite resultierenden 8 Dateneingangsleitungen werden nun paarweise über jeweils ein weiteres Multiplexelement, eines Bypass/Schreibzugriff-Zeitmultiplexelement BSMUX bezeichnet werden kann, zusammengefaßt. Somit sind in dieser Anordnung 8 dieser Bypass/Schreibzugriff-Zeitmultiplexer BSMUX vorgesehen. Der jeweilige Ausgang dieser Zeitmultiplexer BSMUX ist mit der jeweiligen Schreibdatenleitung zum Speicherbaustein RAM verknüpft. Dieser hier aus 8 Multiplexelementen pro Ebene bestehende Bypass/Schreibzugriff-Zeitmultiplexer BSMUX ist funktional dafür verantwortlich, daß sowohl das Bypassing, daß heißt das direkt Durchschleusen von Daten von Port zu Port als auch der Schreibzugriff auf den Speicherbaustein RAM koordiniert wird. Direkt vor dem Eingang zum Speicherbaustein RAM sind nochmals weitere RAM-Schreibdatenregister SR der Anzahl 0-7 angeordnet. Diese sind nur auf dem Schreibdatenpfad des Speicherelementes vorgesehen. Desweiteren weist das Speicherelement RAM auch noch jeweils Lesedatenpfade auf. Insgesamt bilden diese Datenpfade die Datentransfer-Anschlußebene DAE des Speicherelementes. Die Lesedatenpfade sind in entsprechender Weise jeweils über Multiplexelemente der Ausgangszeitmultiplexer AMUX2 mit den Registerelementen 0-7 der Datenausgangsregister DAR der Ports verbunden. Die Schreibzugriffspfade bzw. die Schreibdatenregisterelemente 0-7 der Registers SR sind dabei mit dem jeweiligen Lesezugriffspfad paarweise auf die jeweiligen Multiplexelemente der Ausgangszeitmultiplexer AMUX2 gelegt.

Die Ausgangszeitmultiplexer AMUX1, welche wie die übrigen Multiplexer AMUX2 und die Register DER und DAR an jedem Port angeordnet sind, koordinieren die Ausgabe von Daten an den Ports. Mit koordinierter Ausgabe von Daten ist hier das koordinierte Entleeren der Registerelemente 0-7 gemeint. Der Zeitmultiplexer BSMUX bzw. dessen Multiplexelemente für die Bypass/Schreibzugriff-Organisation koordiniert den Ablauf so, daß die an einem oder mehreren Ports ankommenden Daten vor dem eigentlichen Schreibvorgang im Speicherbaustein RAM nochmals zwischengespeichert werden können, nämlich in den Schreibdatenregistern SR, und die eigentlichen Datenpfade zwischen den Ports für ein direktes Bypassing einer neuen Datentransaktion wieder frei sind, und daß vor dem Schreibvorgang in den Speicherbaustein RAM auch schon möglicherweise zeitgleich wieder Daten heraus gelesen und an die entsprechenden Ports weitergeschleust werden können.

Die Register, daß heißt die Dateneingangsregister DER, und die Datenausgangsregister DAR sowie die RAM-Schreibdatenregister SR sind hierbei, wie oben bereits gesagt, nur in einer der n Ebenen dargestellt. Das heißt in der Senkrechten aus der Papierebene heraus sind diese Register 9 Bit hoch.
Anschaulich gesprochen heißt das, die Datenworte stehen hierbei senkrecht zur Papierebene. Somit ergibt sich, daß die in Fig. 1 dargestellten Datenregister DER, DAR, und SR in der Senkrechten als 8 bzw. 9 Bit breite Wortregister zu verstehen sind.

Das Wesen der Erfindung besteht nun darin, daß durch die Taktung der Wortregister bereits eine koordinierte Vorbereitung zum Raummultiplex des Speicherelementes RAM vorgenommen wird. Die zeitliche Koordination dieses Raummultiplex über die besagten ortsmäßig sowie funktionmäßig beschriebenen Multiplexelemente führt zu der entsprechenden besagten Kombination von Raummultiplex und Zeitmultiplex. Wichtig ist im übrigen hier zu erwähnen, daß jede der 9 Ebenen, welche sich senkrecht aus der Papierebene heraus erstreckt jeweils identisch zu der hier dargestellten Ebene aufgebaut ist. Das heißt die Verschaltungen wie hier dargestellt, sind jeweils nur in der Ebene vorhanden. Die 9 Ebenen sind datenseitig nicht untereinander verschaltet.

Anhand von Fig. 1 läßt sich ebenfalls die verfahrensgemäße Erfindung darstellen bzw. erläutern. Faßt man 2 oder mehrere Ports zu einem logisch breiteren Port zusammen, so werden die einzelnen Datenausgang bzw. Dateneingangsregister DAR, DER zueinander koordiniert bzw. logisch verknüpft ein- und ausgelesen.
Bei dem hier vorliegenden Beispiel von 4 Ports heißt das, daß die Datenregister in der folgenden Weise benutzt werden.
Über das Port A werden die Registerelemente 0 und 1 der Register DAR, DER und SR bedient, über das Port B die Registerelemente 2 und 3 der Register DAR, DER und SR, über Port C die Registerelemente 4 und 5 der Register DAR, DER und SR und über Port D die Registerelemente 6 und 7 der Register DAR, DER und SR bedient. Wichtig ist auch hierbei zu erwähnen, daß jedes der einzelnen Registerelemente 0 - 7 der Register DAR, DER sowie SR jeweils 9 Bit hoch ist.

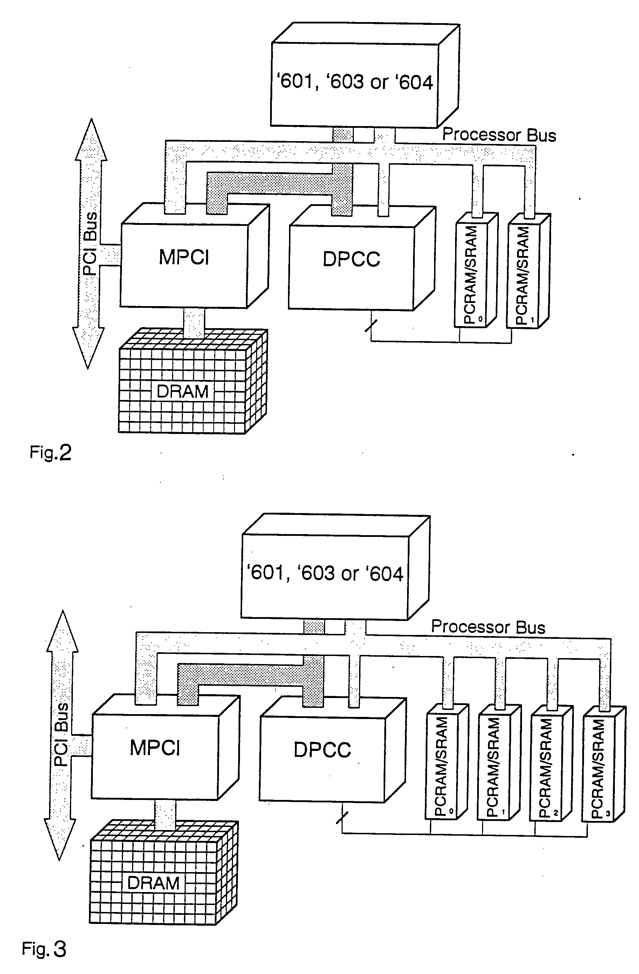

In Fig. 2 wird das Multi-Port-RAM derart betrieben, daß alle vier Ports logisch zu einem Port verknüpft sind. Das RAM erscheint nach außen als 36-Bit-breites single-port RAM. Die Auswahl (Raum-Multiplex) der am Zeit-Multiplex beteiligten Register wird entsprechend für jeden Port individuell festgelegt.

In Fig. 3 werden zwei Ports des Multi-Port-RAM logisch zu einem Port zusammengefaßt. Die beiden anderen Ports bleiben hier unbenutzt. Das RAM erscheint nach außen als 18 Bit breites single-Port-RAM. Die Auswahl (Raum-Multiplex) der am Zeit-Multiplex beteiligten Register wird entsprechend für jedes Port individuell festgelegt.

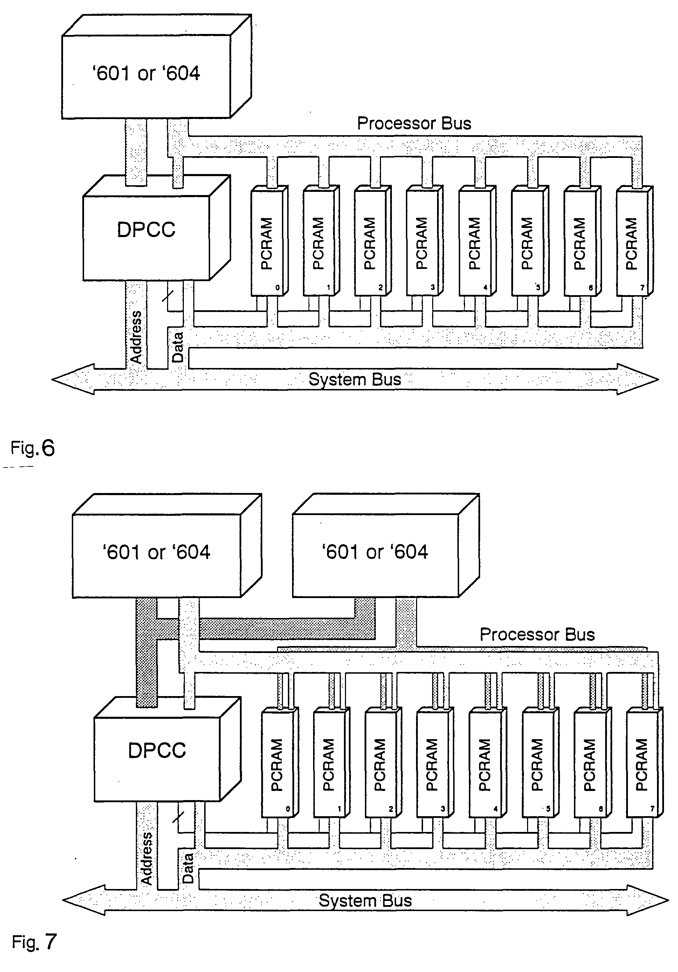

In Fig. 4 werden jeweils zwei Ports des Multi-Port-RAM logisch zu einem Port zusammengefaßt. Ein Paar wird für die Prozessorseite des hierarchischen Caches verwendet, das andere für die Systembusseite. Das RAM erscheint nach außen als jeweils 18 Bit breites dual-port RAM.
Die Auswahl (Raum-Multiplex) der am Zeit-Multiplex beteiligten Register wird entsprechend für jedes Port individuell festgelegt. Die beiden logischen Ports können sowohl unabhängig voneinander, als auch bei direkten Zugriffen von einem Port zum anderen in entsprechend gekoppelter Weise betrieben werden.

In Fig. 5 wird nur ein Port des Multi-Port-RAM verwendet. Die übrigen drei Ports bleiben ungenutzt. Das RAM erscheint nach außen als 9 Bit breites single-port RAM. Die Auswahl (Raum-Multiplex) der am Zeit-Multiplex beteiligten Register wird entsprechend für den genutzten Port festgelegt.

In Fig. 6 werden zwei Ports des Multi-Port-RAM verwendet. Ein Port wird für die Prozessorseite des hierarchischen Caches verwendet, der andere für die Systembusseite. Das RAM erscheint nach außen als jeweils 9 Bit breites dual-port RAM. Die Auswahl (Raum-Multiplex) der am Zeit-Multiplex beteiligten Register wird entsprechend für jedes Port individuell festgelegt. Die beiden Ports können sowohl unabhängig voneinander, als auch bei direkten Zugriffen von einem Port zum anderen in entsprechend gekoppelter Weise betrieben werden.

In Fig. 7 werden 3 Ports des Multi-Port-RAM verwendet. Zwei Ports werden auf der Prozessorbusseite des hierarchischen Caches verwendet, wobei jeder Port mit einem Prozessor verbunden ist. Der dritte Port wird für die Systembusseite verwendet. Die drei Ports können unabhängig voneinander betrieben werden. Bei direkten Zugriffen zwischen einem der Prozessor-Ports und dem Systembus-Port können die beteiligten Ports in entsprechender Weise gekoppelt werden.

Der jeweils andere Prozessor-Port ist während dieser Kopplung von einer Kopplung mit dem Systembus ausgeschlossen. Darüber hinaus können auch die beiden Prozessorbus-Ports gekoppelt werden (z.B.für Cache-to-Cache transfer).

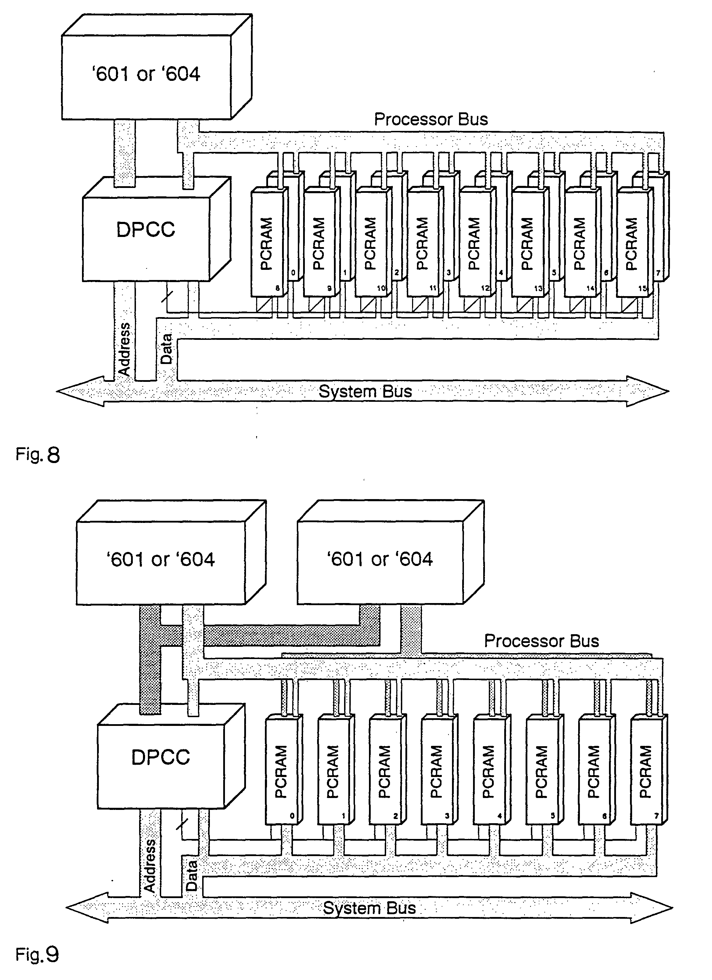

Fig.8 und Fig.9 entsprechen Fig.6 und Fig. 7. Der einzige Unterschied besteht in der Verdopplung der Cachegröße durch Parallelschalten von jeweils zwei RAM.

Darüber hinaus werden weitere Konfigurationen unterstützt. Ein exemplarisches Beispiel ist die Verknüpfung zweier Ports zu einem 18 Bit breiten logischen Port für die Prozessorseite und die Verwendung eines der verbleibenden Ports für die Systembusseite. Nach außen erscheint das RAM als asymetrisches Multi-Port-RAM mit 18 Bit breitem Prozessor Port und 9 Bit breitem Systembusport. Auf der Prozessorbusseite muß beim Anschluß des Prozessor auf den notwendigen Interleave der Datenanschlüße geachtet werden.

### Bezugszeichenliste

- RAM =: Speicherelement
- RC =: RAM-Controler / Adress-Controler
- PORT =: Port = Tor
- A,B,C,D =: Port A, Port B, .....
- 0.....7 =: Registerelemente
- DAR =: Datenausgangsregister
- DER =: Dateneingangsregister
- SR =: RAM-Schreibdatenregister
- DAE =: Datentransferanschlußebene
- BSMUX =: Bypass/Schreibgriff-Zeitmultiplexer
- AMUX 1, AMUX 2=: Ausgangszeitmultiplexer
- EMUX =: Eingangszeitmultiplexer
- m =: Anzahl der Datenworte
- n =: Breite der Ports

## Patentansprüche

1. Mehrtorige Datenspeicheranordnung für Computer, mit mindestens einem Schreib-Lese-Speicherelement, mit zwischen den Toren und dem Speicherelement angeordneten Datenregistern und Zeitmultiplexmitteln zum koordinierten Datentransfer zwischen den Toren und dem Speicherelement,
**dadurch gekennzeichnet,**
daß die Tore (A,B,C,D) jeweils eine Wortbreite von n Bit aufweisen, daß das Speicherelement (RAM) n Ebenen aufweist, und jede Ebene einem der n Bits zugeordnet ist,
daß auf jeder Ebene das Speicherelement m Bits breit ist, wobei m größer oder gleich 2 ist, und eine Datentransfer-Anschlußebene (DAE) mit einem Dateneingang und einem Datenausgang für jedes der m Bits aufweist, und daß auf jeder Ebene die genannten Datenregister und Zeitmultiplexmittel vorgesehen sind um einerseits die genannten Tore untereinander und andererseits die genannten Tore mit den genannten Datenein/ und -ausgängen zu verbinden.

2. Mehrtorige Datenspeicheranordnung nach Anspruch 1,
**dadurch gekennzeichnet,**
daß die Speicheranordnung im Computer als Cache-Speicheranordnung eingesetzt ist.

3. Mehrtorige Datenspeicheranordnung nach Anspruch 1 oder 2,
**dadurch gekennzeichnet,**
daß jedes Tor (A,B,C,D...) sowohl Dateneingangsregister (DER) als auch Datenausgangsregister (DAR) enthält, die nach einer jeweils eigenen Struktur derart verschaltet sind, daß je eine komplette, maximale Transaktion der Länge BS in empfangender und sendender Richtung zwischengespeichert werden kann.

4. Mehrtorige Datenspeicheranordnung nach Anspruch 3,
**dadurch gekennzeichnet,**
daß jedes Datenregister (DER, DAR) in jeder der n Ebenen aus jeweils einer Anzahl von m Registerelementen (0,1,2,.....7..) besteht.

5. Mehrtorige Datenspeicheranordnung nach Anspruch 4,
**dadurch gekennzeichnet,**
daß direkt vor der Datentransfer-Anschlußebene (DAE) in jeder der n Ebenen eine Anzahl m RAM-Schreibdatenregister (SR) in Schreibzugriffsrichtung angeordnet ist.

6. Mehrtorige Datenspeicheranordnung nach Anspruch 5,
**dadurch gekennzeichnet,**
daß die Datenausgangsregister (DAR) über Zeitmultiplexelement (AMUX 2) mit den Lesezugriffspfaden der Datentransfer-Anschlußebene (DAE) des Speicherelementes (RAM) und den Ausgängen von Bypass/Schreibzugriff-Zeitmultiplexern (BSMUX) verbunden sind.

7. Mehrtorige Datenspeicheranordnung nach Anspruch 6,
**dadurch gekennzeichnet,**
daß die jeweiligen Dateneingangsregister (DER) zweier Ports so zusammengeschaltet sind, daß die Registerelemente (0-7) paarweise, das heißt Registerelement 0 vom Dateneingangregister (DER) von Port A mit Registerelement 0 vom Dateneingangsregister (DER) von Port B u.s.w., jeweils auf einen Eingangszeitmultiplexer (EMUX) zusammengeführt sind.

8. Mehrtorige Datenspeicheranordnung nach Anspruch 7,
**dadurch gekennzeichnet,**
daß bei einer Anordnung mit 4 Ports die Ausgänge der einzelnen Eingangszeitmultiplexer (EMUX) jeweils zusammen auf ein jeweiliges Bypass/Schreibzugriff-Zeitmultiplexelement (BSMUX) zusammengefaßt sind.

9. Mehrtorige Datenspeicheranordnung nach Anspruch 8,
**dadurch gekennzeichnet,**
daß die Ausgänge der so entstehenden 8 Bypass/Schreibzugriff-Zeitmultiplexer (BSMUX) auf die Schreibzugriffleitungen der RAM-Schreibdatenregister (SR) geschaltet sind.

10. Mehrtorige Datenspeicheranordnung nach einem oder mehreren der vorhergehenden Ansprüche,
**dadurch gekennzeichnet,**
daß die gesamte Anordnung bestehend aus Speicherelement (RAM), Ports (PORT A, B, C, D), Register (DAR, DER, SR) sowie Zeitmultiplexer (EMUX, AMUX 1, AMUX 2, BSMUX) und ein Controler (RC) auf einem zusammenhängenden Chipelement implementiert sind.

11. Verfahren zum Betrieb einer mehrtorigen Datenspeicheranordnung für Computer, bei welcher die Daten über Tore (Ports) in ein Schreib-Lese-Speicherelement ein- oder ausgelesen, oder Daten zwischen den Toren direkt durchgereicht werden können, unter Verwendung einer Anordnung nach Anspruch 1,
**dadurch gekennzeichnet,**
daß von der Gesamtzahl x der Tore, auch Ports genannt Gruppen von k = 2 ^{L} Ports, mit k ≤ x (k kleiner oder gleich x, L = ganze Zahlen), derart logisch zusammengefaßt werden können, daß Ports der k-fachen Breite entstehen, indem den logischen Teilports jeweils fest vorgegebene Teile der aus m Registern bestehenden Registersätze und des aus m Worten bestehenden Speicherelementes zugewiesen werden.

12. Verfahren zum Betrieb einer mehrtorigen Datenspeicheranordnung für Computer nach Anspruch 11,
**dadurch gekennzeichnet,**
daß die Anzahl der Tore x = 4 ist und die Zahl der Register in den Registersätzen, bzw. die Zahl der Speicherelemente m = 8 ist, und daß für diesen Fall am Port A nur die Registerelemente 0 und 4, am Port B nur die Registerelemente 1 und 5, am Port C nur die Registerelemente 2 und 6, und am Port D nur die Registerelemente 3 und 7 genutzt bzw. beschrieben und ausgelesen werden.

13. Verfahren zum Betrieb einer mehrtorigen Datenspeicheranordnung für Computer nach Anspruch 11,
**dadurch gekennzeichnet,**
daß die Anzahl der Tore x = 4 ist und die Zahl der Register in den Registersätzen, bzw. die Zahl der Speichersegmente m = 6 ist, und daß für diesen Fall an den Ports A und C nur die Registerelemente 0, 2, 4 und 6 und an-den Ports B und D nur die Registerelemente 1, 3, 5 und 7 genutzt bzw. beschrieben und ausgelesen werden.

14. Verfahren zum Betrieb eine mehrtorigen Datenspeicheranordnung für Computer nach Anspruch 11,
**dadurch gekennzeichnet,**
daß zur Anpassung von Busbreiten unterschiedliche logische Ports mit unterschiedlicher Wortbreite betrieben werden.

## Claims

1. A multi-port data memory configuration for computing equipment, with at least one read-write memory element, with data registers and time multiplex means between the memory element and its ports for coordinated transfer between the ports and the memory element,
characterised by,
the ports (A, B, C, D) each having a width of n bits, the memory element (RAM) having n segments, where each segment is associated with one of the n bits, the memory element is m bits wide within each segment, where m is greater than or equal to two, and it has a data transfer stage (DAE) with one data input and one data output for each of the m bits and each segment has the noted data registers and time multiplex means to connect the ports among each other as well as the ports with the noted data inputs and outputs.

2. A multi-port data memory configuration according to claim 1,
characterised by,
the memory configuration being used as cache memory configuration in computing equipment.

3. A multi-port data memory configuration according to claim 1 or 2,
characterised by,
each port (A, B, C, D) having a data input register (DER) as well as a data output register (DAR), interconnected by their own internal structure such that a complete, maximum transaction of length BS in each, sending and receiving direction can be stored intermediately.

4. A multi-port data memory configuration according to claim 3,
characterised by,
each data register (DER, DAR) being made out of m register elements (0, 1, 2, ..., 7, ..) in each of the n stages.

5. A multi-port data memory configuration according to claim 4,
characterised by,
m RAM data write registers (SR) being located directly in front of the data transfer stage (DAE) in each of the n segments in write access direction.

6. A multi-port data memory configuration according to claim 5,
characterised by,
the data output registers (DAR) being connected via a time multiplex element (AMUX2) with the read access path of the data transfer stage (DAE) of the memory element (RAM) and with the outputs of bypass/write access time multiplexers (BSMUX).

7. A multi-port data memory configuration according to claim 6,
characterised by,
the respective data input registers (DER) of the two ports being interconnected such that the register elements (0-7) are combined with one input time multiplexer as pairs, i.e. register element 0 of the data input register (DER) of port A with register element 0 of the data input register (DER) of port B, and so forth.

8. A multi-port data memory configuration according to claim 7,
characterised by,
a configuration with 4 ports having the outputs of the individual input time multiplexers (EMUX) combined together with one respective bypass/write access time multiplexer (BSMUX).

9. A multi-port data memory configuration according to claim 8,
characterised by,
the outputs of the resulting 8 bypass/write access time multiplexers (BSMUX) being connected with the write access lines of the RAM write data register (SR).

10. A multi-port data memory configuration according to one or several of the above claims,
characterised by,
the complete configuration consisting of memory element (RAM), ports (A, B, C, D,), registers (DAR, DER, SR), as well as time multiplex elements (EMUX, AMUX1, AMUX2, BSMUX) and a controller (RC) being integrated on a single semiconductor device.

11. Method to operate a multi-port data memory configuration for computing equipment, which can transfer data via ports into or out of a read/write memory element or pass the data directly between the ports, using a configuration according to claim 1,
characterised such,
that from the total number x of ports groups of k = 2^{L} ports where k ≤ x (k smaller or equal to x, L = integer number) can logically combined such that ports of k-fold width are created by assigning pre-selected parts of the register sets consisting of m registers and the memory element consisting of m words to the logical port groups.

12. Method to operate a multi-port data memory configuration for computing equipment according to claim 11,
characterised such,
that the number of ports is x = 4 and the number of registers in the register sets, respectively the number of memory segments is m = 8, and that in this case at port A only register elements 0 and 4, at port B only register elements 1 and 5, at port C only register elements 2 and 6 and at port D only register elements 3 and 7 are used, i.e. written to or read from.

13. Method to operate a multi-port data memory configuration for computing equipment according to claim 11,
characterised such,
that the number of ports is x = 4 and the number of register in the register sets, respectively the number of memory segments is m = 6, and that in this case at ports A and C only register elements 0, 2, 4, and 6 and at ports B and D only register elements 1, 3, 5, and 7 are used, i.e. written to or read from.

14. Method to operate a multi-port data memory configuration for computing equipment according to claim 11,
characterised by,
operating separate logic ports with different word width to adapt between different bus widths.

## Revendications

1. Agencement de mémoire de données de type multiport pour des ordinateurs, comprenant au moins un élément de mémoire à lecture-écriture, des registres de données et des agents de multiplexage dans le temps disposés entre les ports et l'élément de mémoire, pour la transmission coordonnée de données entre les ports et l'élément de mémoire, caractérisé en ce que les ports (A, B, C, D) présentent respectivement une longueur de mots de n bits, en ce que l'élément de mémoire (RAM) présente n plans, chaque plan étant attribué à un des n bits, en ce que, sur chaque plan, l'élément de mémoire possède une longueur de m bits, m étant supérieur ou égal à 2, et présente un plan de connexion pour la transmission de données (DAE) avec une entrée de données et une sortie de données pour chacun des m bits, et en ce que, sur chaque plan, les registres de données et les agents de multiplexage dans le temps mentionnés sont prévus pour relier d'une part, les ports mentionnés les uns aux autres et d'autre part, les ports mentionnés aux entrées et aux sorties de données mentionnées.

2. Agencement de mémoire de données de type multiport selon la revendication 1, caractérisé en ce que l'agencement de mémoire est mis en oeuvre dans l'ordinateur sous la forme d'un agencement de mémoire cache.

3. Agencement de mémoire de données de type multiport selon la revendication 1 ou 2, caractérisé en ce que chaque port (A, B, C, D...) contient aussi bien des registres d'entrée de données (DER) que des registres de sortie de données (DAR) qui sont reliés conformément à une structure respectivement propre de telle sorte qu'une transaction maximale complète respective de longueur BS peut être mise en mémoire tampon dans le sens de la réception et dans le sens de l'émission.

4. Agencement de mémoire de données de type multiport selon la revendication 3, caractérisé en ce que chaque registre de données (DER, DAR) dans chacun des n plans est constitué respectivement d'un nombre de m éléments de registres (0,1,2,.....7).

5. Agencement de mémoire de données de type multiport selon la revendication 4, caractérisé en ce que, directement avant le plan de connexion pour la transmission de données (DAE), est disposé, dans chacun des n plans, un nombre m de registres de données d'écriture de type RAM (SR) dans la direction d'accès par écriture.

6. Agencement de mémoire de données de type multiport selon la revendication 5, caractérisé en ce que les registres de sortie de données (DAR) sont reliés via un élément de multiplexage dans le temps (AMUX 2) avec les chemins d'accès par lecture du plan de connexion pour la transmission de données (DAE) de l'élément de mémoire (RAM) et avec les sorties de multiplexeurs dans le temps de type dérivation/accès par écriture (BSMUX).

7. Agencement de mémoire de données de type multiport selon la revendication 6, caractérisé en ce que les registres d'entrée de données respectifs (DER) de deux ports sont interconnectés de telle sorte que les éléments de registres (0-7) sont concentrés respectivement sur un multiplexeur d'entrée dans le temps (EMUX) par paires, c'est-à-dire l'élément de registre 0 du registre d'entrée de données (DER) du port A avec l'élément de registre 0 du registre d'entrée de données (DER) du port B, etc.

8. Agencement de mémoire de données de type multiport selon la revendication 7, caractérisé en ce que, dans un agencement à 4 ports, les sorties des multiplexeurs individuels d'entrée dans le temps (EMUX) sont regroupés respectivement sur un élément de multiplexage dans le temps de type dérivation/accès par écriture (BSMUX) respectif.

9. Agencement de mémoire de données de type multiport selon la revendication 8, caractérisé en ce que les sorties des 8 multiplexeurs dans le temps de type dérivation/accès par écriture (BSMUX) ainsi obtenus sont montés sur les circuits d'accès par écriture des registres de données d'écriture de type RAM (SR).

10. Agencement de mémoire de données de type multiport selon une ou plusieurs des revendications précédentes, caractérisé en ce que l'agencement dans son ensemble constitué par un élément de mémoire (RAM), par des ports (PORT A, B, C, D), par des registres (DAR, DER, SR), ainsi que par des multiplexeurs dans le temps (EMUX, AMUX 1, AMUX 2, BSMUX) et par un contrôleur (RC) est mis en oeuvre sur un élément en forme de puce intégrée.

11. Procédé pour la mise en service d'un agencement de mémoire de données de type multiport pour des ordinateurs, par lequel les données peuvent être introduites ou extraites via des ports dans un élément de mémoire à lecture-écriture ou bien des données peuvent être transmises directement entre les ports, en utilisant un agencement selon la revendication 1, caractérisé en ce que l'on peut procéder à un regroupement de type logique, à partir du nombre total x des ports, des groupes de k = 2^{L} ports, où k ≤ x (k est inférieur ou égal à x, L = des nombres entiers) de telle sorte que l'on obtient des ports dont la longueur représente un multiple de k, dans lequel on attribue aux ports partiels logiques respectivement des parties prédéfinies en permanence des phrases de registres constituées par m registres et de l'élément de mémoire constitué par m mots.

12. Procédé pour la mise en service d'un agencement de mémoire de données de type multiport pour des ordinateurs selon la revendication 11, caractérisé en ce que le nombre des ports x = 4 et le nombre des registres dans les phrases de registres, respectivement le nombre des éléments de mémoire m = 8, et en ce que, dans ce cas, on ne peut utiliser, respectivement introduire et extraire, au port A que les éléments de registres 0 et 4, au port B que les éléments de registres 1 et 5, au port C que les éléments de registres 2 et 6 et au port D que les éléments de registres 3 et 7.

13. Procédé pour la mise en service d'un agencement de mémoire de données de type multiport pour des ordinateurs selon la revendication 11, caractérisé en ce que le nombre des ports x = 4 et le nombre des registres dans les phrases de registres, respectivement le nombre des segments de mémoire m = 6, et en ce que, dans ce cas, on ne peut utiliser, respectivement introduire et extraire, aux ports A et C que les éléments de registres 0, 2, 4 et 6 et aux ports B et D que les éléments de registres 1, 3, 5 et 7.

14. Procédé pour la mise en service d'un agencement de mémoire de données de type multiport pour des ordinateurs selon la revendication 11, caractérisé en ce que, à des fins d'adaptation aux longueurs de bus, on met en service des ports logiques différents avec des longueurs de mots différentes.
